# FASCICULE DE BREVET EUROPEEN

(11) **EP 3 531 173 B1**
(45) Date de publication et mention de la délivrance du brevet: **27.07.2022**
(21) Numéro de dépôt: 19158946.4
(22) Date de dépôt: 22.02.2019
(51) Int. Cl.: G02B 1/18, G02B 27/00

(54) **ÉLÉMENT OPTIQUE POUR VÉHICULE AUTOMOBILE**
OPTISCHES ELEMENT FÜR KRAFTFAHRZEUG
OPTICAL ELEMENT FOR MOTOR VEHICLE

(30) Priorité: 26.02.2018 FR 1851639
(43) Date de publication de la demande: 28.08.2019
(73) Titulaire: Valeo Vision, 93012 Bobigny Cedex (FR)
(72) Inventeur: REVOL, Damien, 93012 BOBIGNY Cedex (FR); BRASSIER, Marc, 93012 BOBIGNY Cedex (FR)
(74) Mandataire: Valeo Visibility

(56) Documents cités:
- EP-A1- 3 208 123
- EP-A2- 0 117 512
- US-A- 6 103 363

## Description

La présente invention se rapporte à un élément optique, notamment transparent, pour véhicule automobile présentant une rugosité de surface caractérisée par un écart quadratique de rugosité Rq supérieur ou égal à 20 nm, à un dispositif lumineux de véhicule automobile comprenant ledit élément optique, ainsi qu'à un procédé de fabrication dudit élément optique.

Elle s'applique typiquement, mais non exclusivement, aux domaines de l'optique, tels que par exemple des dispositifs lumineux, en particulier du type dispositifs d'éclairage et/ou de signalisation lumineuse, notamment pouvant être utilisés à l'extérieur et/ou à l'intérieur de véhicules automobiles.

Les dispositifs lumineux, tels que par exemple un projecteur avant ou un feu arrière, comprennent typiquement au moins un élément optique, notamment transparent, tel qu'une glace intérieure, une glace extérieure, une lentille, une paroi externe, une paroi interne, un guide de lumière, en particulier pour des projecteurs, des feux, des caméras, ou des miroirs de rétroviseurs. Un tel élément optique présente l'inconvénient de se recouvrir de buée lorsque la température de sa surface descend au-dessous du point de rosée de l'air ambiant. La formation de buée sur sa surface entraîne une diminution de la transparence, due à la diffusion de la lumière par les gouttes d'eau, ce qui peut provoquer une gêne importante. Par ailleurs, des salissures organiques et minérales peuvent adhérer à la glace transparente rendant son nettoyage et son entretien difficile.

Pour éviter la formation de buée, c'est-à-dire la condensation de fines gouttelettes d'eau sur un support, et/ou pour obtenir des propriétés autonettoyantes, il est connu de déposer une couche superhydrophile sur un substrat. Ainsi, il est connu de préparer un revêtement antibuée et autonettoyant, sous la forme d'une couche, comprenant à la fois de l'oxyde de titane et de l'oxyde de silicium. La couche est obtenue par combustion et/ou pyrolyse de précurseurs de l'oxyde de titane et de l'oxyde de silicium, dans une flamme, par exemple par flammage du type « flamespray pyrolysis » (FSP), « flame assisted spray pyrolysis » (FASP), ou « liquid flame spray » (LSF). Toutefois, les propriétés de nettoyage ne sont pas optimisées. Le document US 6 103 363 A divulgue un élément optique pour véhicule automobile comprenant au moins une première couche transparente de verre ou de céramique et au moins une deuxième couche comprenant au moins du silicium, du titane, et de l'oxygène, l'élément optique présentant une rugosité de surface définie par un écart moyen quadratique Rq supérieur ou égal à 20 nm. Le document EP 3 208 123 A1 divulgue l'emploi d'un élément optique pour véhicule automobile contenant un matériau polymère et comprenant une couche d'oxyde de silice.

Le but de la présente invention est de pallier les inconvénients des techniques de l'art antérieur en proposant un élément optique, notamment transparent, pour véhicule automobile présentant des propriétés nettoyantes améliorées tout en garantissant de bonnes propriétés antibuée dans le temps, notamment pendant une durée d'au moins deux ans.

La présente invention a pour premier objet un élément optique, notamment transparent, pour véhicule automobile, comprenant au moins une première couche transparente contenant un matériau polymère, et au moins une deuxième couche comprenant au moins du silicium, du titane, et de l'oxygène, caractérisé en ce que l'élément optique présente une rugosité de surface définie par un écart moyen quadratique Rq supérieur ou égal à 20 nm.

Grâce à l'invention, l'élément optique, en configuration opérationnelle, présente des propriétés de nettoyage améliorées. En particulier, la rugosité de surface conférée à l'élément optique permet de diminuer l'adhérence des contaminants et salissures à la surface dudit élément tout en garantissant de bonnes propriétés antibuée. En outre, l'élément optique de l'invention est facile à fabriquer et garantit des propriétés homogènes sur l'ensemble de la surface dudit élément.

Dans la présente invention, on entend par « élément transparent ou couche transparente », un élément ou une couche transmettant la lumière visible par réfraction et au travers duquel/de laquelle les objets sont visibles avec plus ou moins de netteté. Plus particulièrement, c'est un élément ou une couche à travers lequel/laquelle une image est observée sans perte significative de contraste : l'interposition dudit élément transparent ou de ladite couche transparente entre une image et un observateur de celle-ci ne réduit pas significativement la qualité de l'image. En effet, au sens de l'invention, un élément transparent peut transmettre au moins une partie de la lumière incidente (ou rayon lumineux incident) avec très peu voire sans dispersion. De préférence, la transmission lumineuse, notamment la transmission de la lumière visible, à travers l'élément transparent ou couche transparente est d'au moins 87% environ. La transmission lumineuse est la quantité de lumière que laisse passer l'élément transparent ou couche transparente à partir d'un rayon lumineux incident. La transmission lumineuse visible est la quantité de lumière visible, correspondant aux ondes électromagnétiques dont la longueur d'onde correspond au spectre visible, soit entre les longueurs d'onde 380 et 780 nm environ, que laisse passer l'élément transparent ou couche transparente à partir d'un rayon lumineux incident.

### La rugosité

L'écart moyen quadratique Rq permettant de définir la rugosité de l'élément optique peut être mesuré à l'aide d'un dispositif avec ou sans contact, tel qu'un profilomètre à palpeur, un profilomètre optique, un dispositif à coupe optique ou un dispositif à force atomique.

Il est de préférence mesuré à l'aide un dispositif à force atomique tel qu'un microscope à force atomique (AFM pour atomic force microscope).

L'écart moyen quadratique de rugosité Rq est défini dans la norme internationale NF EN ISO 4287.

L'élément optique conforme au premier objet de l'invention présente de préférence une rugosité définie par un écart moyen quadratique d'au moins 25 nm environ, de préférence d'au moins 50 nm environ, et de préférence encore d'au moins 100 nm environ.

L'élément optique conforme à l'invention possède avantageusement une rugosité nanométrique suffisante pour induire une réduction de l'adhérence des contaminants sur la surface hydrophile de l'élément optique, l'hydrophilie étant conférée par la deuxième couche comprenant au moins du silicium, du titane, et de l'oxygène, dudit l'élément optique. Ainsi, l'élimination des salissures organiques et minérales s'en retrouve améliorée.

Selon une forme de réalisation particulièrement préférée de l'invention, l'écart moyen quadratique est d'au plus 200 nm environ, et de préférence encore d'au plus 150 nm environ.

La rugosité de l'élément optique peut avoir une forme en créneaux.

Les créneaux peuvent présenter une hauteur allant de 100 à 200 nm environ.

Chacun des créneaux peut être à une distance allant de 50 à 500 nm environ d'un autre créneau adjacent. Cette distance est notamment appelé le pas des créneaux.

Les créneaux peuvent être du type parallélépipède (e.g. tronc de pyramide), carré, rectangulaire, triangulaire, ou sinusoïdal.

### La deuxième couche

Grâce à la deuxième couche comprenant au moins du silicium, du titane, et de l'oxygène, l'élément optique de l'invention présente notamment une activité photocatalytique.

L'activité photocatalytique permet de réaliser des réactions chimiques en présence de lumière. Son principe repose sur la génération de paires électron-trou dans un matériau semi-conducteur par absorption de photons dont l'énergie est au moins égale à la largeur de bande interdite du matériau. Ces porteurs de charge vont ensuite réagir avec des espèces chimiques en surface du matériau, telles que des résidus d'hydrocarbures provenant des gaz d'échappement d'automobiles ou des contaminants, par photocatalyse oxydante. La photocatalyse entraine la rupture des liaisons organique des résidus ou des contaminants organiques, et donc leur dégradation. L'élimination se fait par entrainement d'un film d'eau condensé et par convection naturelle du dispositif lumineux.

Selon une forme de réalisation particulièrement préférée de l'invention, la deuxième couche comprend en outre au moins un dopant choisi parmi les éléments chimiques du tableau périodique des éléments ayant une dimension atomique variant de 1 à 4 À.

L'activité photocatalytique de l'élément optique de l'invention peut alors être réalisée à des longueurs d'onde λ allant de 380 nm à 780 nm (lumière visible), et de préférence à des longueurs d'onde λ supérieures ou égales à 400 nm.

Le dopant permet de substituer partiellement l'oxygène de la deuxième couche.

Le dopant peut être choisi parmi l'azote, le carbone, le soufre, le phosphore, le bore, le fluor, le chlore, le fer, le nickel, le cobalt, le chrome, le vanadium, le molybdène, le niobium, le tungstène, le platine, et l'aluminium.

Selon une forme de réalisation préférée de l'invention, le dopant est l'azote ou le carbone, et de manière avantageuse l'azote.

La deuxième couche de l'élément optique de l'invention peut comprendre :
- un ou plusieurs groupement(s) silicium-oxygène (Si-O), et
- un ou plusieurs groupement(s) titane-oxygène (Ti-O).

Lorsque la deuxième couche comprend en outre un dopant, elle peut comprendre en outre un ou plusieurs groupement(s) titane-dopant, et de préférence un ou plusieurs groupement(s) (Ti-N) ou (Ti-C).

Dans la présente invention, on entend par :
- « groupement silicium-oxygène », un groupement comprenant au moins un atome de silicium lié de façon covalente à un atome d'oxygène (Si-O) ;
- « groupement titane-oxygène », un groupement comprenant au moins un atome de titane lié de façon covalente à un atome d'oxygène (Ti-O) ; et
- « groupement titane-dopant », un groupement comprenant au moins un atome de titane lié de façon covalente à un atome de dopant (Ti-dopant).

L'analyse de la structure de la deuxième couche peut être réalisée par MEB/EDS (Microscope Electronique à Balayage avec sonde pour spectroscopie à dispersion d'énergie).

Dans un mode de réalisation particulier de l'invention, lorsque le dopant est l'azote, la deuxième couche comprend un dérivé azoté de dioxyde de titane, et plus particulièrement un dérivé de dioxyde de titane dopé à l'azote.

De préférence, le dérivé azoté de dioxyde de titane a pour formule TiO₂₋ₓNₓ avec 0,001 < x < 1,00, de préférence avec 0,01 ≤ x ≤ 0,10, et plus préférentiellement avec x = 0,02.

La deuxième couche peut comprendre en outre du dioxyde de silicium.

La deuxième couche de l'élément optique de l'invention peut comprendre environ de 30% à 90% en poids de silicium, et de préférence environ de 40% à 70% en poids de silicium, par rapport au poids total de la deuxième couche.

La deuxième couche de l'élément optique de l'invention peut comprendre environ de 1% à 70% en poids de titane, et de préférence environ de 5% à 30% en poids de titane, par rapport au poids total de la deuxième couche.

La deuxième couche de l'élément optique de l'invention peut comprendre environ de 40% à 60% en poids d'oxygène, et de préférence environ de 45% à 55% en poids d'oxygène, par rapport au poids total de la deuxième couche.

La deuxième couche de l'élément optique de l'invention peut comprendre environ de 0,0001% à 10% en poids de dopant, de préférence environ de 0,001% à 5% en poids de dopant, de préférence environ de 0,02% à 2% en poids de dopant, et de préférence environ de 0,01% à 0,1% en poids de dopant, par rapport au poids total de la deuxième couche.

Le rapport massique silicium/titane peut varier préférentiellement environ de 70/30 à 90/10.

La détermination des différents pourcentages en poids indiqués ci-dessus peut être classiquement réalisée par spectroscopie d'analyse élémentaire par exemple XPS (Spectroscopie de Photoélectrons X).

Dans la présente invention, la deuxième couche peut être obtenue à partir d'au moins un précurseur PR1 comprenant de l'oxygène et du silicium, et d'au moins un précurseur PR2 comprenant de l'oxygène et du titane.

On entend par « précurseur » tout composé, pris seul ou en combinaison, permettant d'obtenir la deuxième couche.

Plus particulièrement, le précurseur PR1 est choisi parmi un silane hydrocarboné, un fluorosilane, un organo-silicate, un monomère de siloxane, le dioxyde de silicium (SiO₂), et un de leurs mélanges.

Le silane hydrocarboné peut être le tétraméthysilane (TMS).

Le fluorosilane peut être le triéthoxyfluorosilane (TEOF).

L'organo-silicate peut être choisi parmi l'orthosilicate de tétraéthyle (TEOS), le tétraméthyl orthosilicate (TMOS), et un de leurs mélanges.

Ledit monomère de siloxane peut être choisi parmi l'hexaméthyldisiloxane (HMDSO), le tétraméthyldisiloxane (TMDSO), l'octaméthylcyclotétrasiloxane (OMCTSO), et un de leurs mélanges.

Dans la présente invention, le précurseur PR2 peut être choisi parmi le tétraisopropoxyde de titane (TTIP), un de ses dérivés, le bis(acétylacétonate) diisopropoxyde de titane (TIPO), l'orthotitanate de tétrabutyle (TBOT), l'orthotitanate de tétrapropyle (TPOT), le citratoperoxotitanate d'ammonium, le tétrakis (9H-carbazole-9-yl-éthyl-oxy) de titane (Ti(OeCarb)₄), le dioxyde de titane (TiO₂), et un de leurs mélanges.

On peut citer comme exemples de dérivés du TTIP :
- l'acétyle acétonate tris isopropoxyde de titane (TAATIP),
- le TTIP modifié par l'éthylène glycol (EGMT), ou
- le TTIP modifié par l'acide acétique (AcOH/TTIP ou C₂H₄O₂/TTIP).

La deuxième couche peut comprendre en outre au moins un élément non-métallique, notamment choisi parmi le carbone (C), le phosphore (P), le fluor (F) et le soufre (S), et/ou au moins un élément métallique, notamment choisi parmi le zinc (Zn), le cuivre (Cu), l'argent (Ag), le fer (Fe) et le cobalt (Co).

L'élément non-métallique (respectivement l'élément métallique) peut être utilisé comme co-dopant. Le dopant tel que défini précédemment est alors en partie substitué dans la deuxième couche par au moins l'élément non-métallique ou métallique précité.

La deuxième couche de l'invention peut comprendre environ de 0,0001% à 10% en poids d'élément métallique ou non métallique, et de préférence environ de 0,01% à 2% en poids d'élément métallique ou non métallique, par rapport au poids total de la deuxième couche.

Les associations d'un co-dopant avec un dopant tel que défini précédemment telles que l'association de fluor (F) avec de l'azote (N) ou l'association de carbone (C) avec de l'azote (N) sont particulièrement appropriées.

La deuxième couche de l'invention peut comprendre en outre un ou plusieurs groupement(s) silicium-oxygène-hydrogène (Si-O-H) (groupes silanols). Cela permet d'améliorer son caractère hydrophile et ainsi, les performances antibuée et de nettoyage de l'élément optique, notamment de par une évacuation des salissures minérales et organiques favorisée.

La deuxième couche de l'élément optique conforme à l'invention peut avoir une épaisseur d'au plus 100 nm environ, et de préférence une épaisseur allant de 30 à 85 nm environ.

Dans un mode de réalisation particulièrement préféré, la deuxième couche est une couche hydrophile, et de préférence encore superhydrophile.

Dans la présente invention, on entend par « hydrophile » un matériau ou une couche dont la surface présente un angle de contact avec l'eau (ou angle de goutte d'eau) strictement inférieur à 80°, et de préférence supérieur ou égal à 10°. On entend plus particulièrement par « superhydrophile », un matériau dont la surface présente un angle de contact avec l'eau inférieur à 10°.

L'élément optique de l'invention peut présenter au moins une surface ayant un angle de contact inférieur à 45°, de préférence inférieur à 20°, et de préférence encore inférieur à 10°. Cela permet d'obtenir un élément optique ayant de bonnes propriétés antibuée.

La mesure de l'angle de contact rend compte de l'aptitude d'un liquide à s'étaler sur une surface par mouillabilité. La méthode consiste à mesurer l'angle de la tangente du profil d'une goutte déposée sur le matériau ou la couche, avec la surface du matériau ou de la couche.

Cet angle de contact est typiquement mesuré à l'aide d'un goniomètre, à 25°C, en utilisant de l'eau distillée.

Dans la présente invention, la deuxième couche peut être déposée directement sur la surface de la première couche transparente. À ce titre, la deuxième couche est directement en contact physique avec la première couche transparente.

Selon un autre mode de réalisation, la deuxième couche peut être déposée indirectement sur la surface de la première couche transparente. À ce titre, une ou plusieurs couche(s) additionnelle(s) peuvent être intercalée(s) entre la première couche transparente et la deuxième couche comprenant au moins du silicium, du titane, et de l'oxygène. Ainsi la deuxième couche n'est pas directement en contact physique avec la première couche.

Une fois la deuxième couche comprenant au moins du silicium, du titane, et de l'oxygène, et les couches additionnelles déposées sur la première couche transparente, la couleur de la première couche est visible au travers de la deuxième couche et des couches additionnelles. La transparence de la deuxième couche et des couches additionnelles est telle que la couleur de la première couche, perçue à travers la deuxième couche et les couches additionnelles est sensiblement la même que la couleur de la première couche. La même couleur signifie que la variation des paramètres L*a*b selon la méthode CIELab respecte notamment les valeurs suivantes ΔL ≤ 2,0, Δa ≤ 1,0, Δb ≤ 1,0, le paramètre L^{∗} définissant la clarté, les paramètres a^{∗} et b^{∗} définissant la chromaticité.

### La première couche transparente

L'élément optique de l'invention comprend une ou plusieurs première(s) couche(s) transparente(s) en un matériau polymère, ou en d'autres termes il comprend une ou plusieurs première(s) couche(s) transparente(s) comprenant un matériau polymère.

Cette première couche transparente peut être appelée substrat ou support.

La première couche transparente peut comprendre au moins 50% en poids environ de matériau polymère, de préférence au moins 60% en poids environ de matériau polymère, de préférence au moins 80% en poids environ de matériau polymère, et de façon particulièrement préférée au moins 95% en poids environ de matériau polymère, par rapport au poids total de la première couche.

Dans un mode de réalisation particulier, la première couche transparente comprend uniquement ledit matériau polymère.

Le matériau polymère de la première couche transparente peut comprendre au moins un polymère P choisi parmi un polycarbonate (PC), un polycarbonate modifié haute température (PC-HT), un polyméthacrylate de méthyle (PMMA), un poly-N-méthyl méthacrylimide (PMMI), un polymère de cyclooléfine (COP pour cyclo olefin polymer), un copolymère de cyclooléfine (COC pour cyclo olefin copolymer), un polysulfone (PSU), un polyarylate (PAR), un polyamide (PA), et un de leurs mélanges.

Le matériau polymère peut comprendre au moins 50% en poids environ du polymère P, de préférence au moins 60% en poids environ du polymère P, de préférence au moins 80% en poids environ du polymère P, et de façon particulièrement préférée au moins 95% en poids environ du polymère P, par rapport au poids total du matériau polymère.

Dans un mode de réalisation particulier, le matériau polymère comprend uniquement un ou plusieurs polymère(s) P.

La première couche transparente de l'élément optique conforme à l'invention peut avoir une épaisseur d'au moins 1,0 mm environ, et de préférence d'au moins 2,5 mm environ.

Elle peut en outre avoir une épaisseur d'au plus 5 mm environ, et de préférence d'au plus 3,5 mm environ.

Le matériau polymère (respectivement le polymère P) présente de préférence un indice de réfraction allant de 1,3 à 1,7 environ.

Le matériau polymère de la couche transparente est transparent, notamment dans toute l'épaisseur considérée de ladite couche.

Selon l'invention, la première couche transparente peut en outre comprendre au moins un additif, notamment bien connu de l'homme du métier et pouvant être choisi parmi :
- des agents colorants tels que des pigments ;
- des agents anti-UV ;
- des agents de protection tels que des antioxydants ;
- des agents de mise en œuvre, tels que des plastifiants, des lubrifiants, des huiles ;
- des agents de réticulation, tels que par exemple des peroxydes organiques; et
- un de leurs mélanges.

Selon une forme de réalisation particulièrement préférée de l'invention, la première couche transparente et/ou la deuxième couche comprenant du silicium, de l'oxygène, et du titane, est une couche gravée.

### Couches additionnelles

L'élément optique peut comprendre en outre une couche transparente de polyorganosiloxane.

La couche transparente de polyorganosiloxane peut être obtenue à partir d'au moins un précurseur PR3 choisi parmi un monomère de siloxane et un monomère de silazane.

À titre d'exemples de monomère de siloxane, on peut citer l'hexaméthyldisiloxane (HMDSO), le tétraméthyldisiloxane (TMDSO), l'octaméthylcyclotétrasiloxane (OMCTSO), ou un de leurs mélanges.

À titre d'exemple de monomère de silazane, on peut citer l'hexaméthyldisilazane (HMDSN).

La couche transparente de polyorganosiloxane peut avoir une épaisseur d'au plus 500 nm environ, et de préférence une épaisseur allant de 10 à 50 nm environ.

La couche transparente de polyorganosiloxane peut être déposée directement sur la première couche transparente. À ce titre, la couche transparente de polyorganosiloxane est directement en contact physique avec la première couche transparente.

Dans ce mode de réalisation, la couche transparente de polyorganosiloxane peut être positionnée entre la première couche transparente et la deuxième couche comprenant du silicium, de l'oxygène, et du titane. À ce titre, la deuxième couche comprenant du silicium, de l'oxygène, et du titane, peut être directement en contact physique avec la couche transparente de polyorganosiloxane.

Selon une forme de réalisation particulièrement préférée de l'invention, la couche transparente de polyorganosiloxane, est une couche gravée.

Dans un mode particulier de l'invention, au moins l'une quelconque des première couche transparente, deuxième couche comprenant du silicium, de l'oxygène, et du titane, et couche transparente de polyorganosiloxane, est une couche gravée.

L'élément optique de l'invention présente notamment des propriétés anti-reflet.

### L'élément optique

L'élément optique, notamment transparent, de l'invention peut être du type glace intérieure, glace extérieure, lentille, paroi externe, paroi interne, guide de lumière, en particulier pour des projecteurs, feux, caméras, ou miroirs de rétroviseurs.

L'élément optique peut faire partie d'un dispositif lumineux du type dispositif d'éclairage et/ou de signalisation lumineuse de véhicule automobile.

Plus particulièrement, l'élément optique peut être une glace de fermeture d'un dispositif lumineux, telle que la glace d'un projecteur avant ou la glace d'un feu arrière de véhicule automobile.

La glace de fermeture d'un dispositif lumineux peut comprendre une face intérieure et une face extérieure, la face extérieure étant celle qui est directement en contact avec l'environnement extérieur ou en d'autres termes la couche directement exposée aux agressions extérieures.

Dans un mode de réalisation particulièrement préféré, la première couche de l'élément optique de l'invention est la face extérieure de ladite glace de fermeture, dans le dispositif lumineux.

En outre, la deuxième couche peut être la face intérieure de ladite glace de fermeture, dans le dispositif lumineux.

Un deuxième objet de l'invention concerne un dispositif lumineux de véhicule automobile comprenant un élément optique, notamment transparent, tel que défini dans le premier objet de l'invention.

En particulier, le dispositif conforme au deuxième objet comprend un boîtier formant un volume dans lequel peut être logée une source lumineuse et/ou un module lumineux, l'élément optique venant fermer ledit boîtier.

Dans un mode de réalisation particulier, ledit dispositif lumineux peut être compris dans un véhicule automobile.

### Le procédé de fabrication de l'élément optique

Un troisième objet de l'invention est un procédé de fabrication d'un élément optique conforme au premier objet de l'invention, caractérisé en ce qu'il comprend, à partir de la première couche transparente, au moins les étapes suivantes :
- une étape de gravure oxydante, et
- une étape de dépôt de la deuxième couche comprenant du silicium, de l'oxygène, et du titane.

L'élément optique de l'invention est facile à fabriquer et garantit des propriétés homogènes sur l'ensemble de la surface traitée par la deuxième couche comprenant du silicium, de l'oxygène, et du titane, et gravée.

La première couche transparente et la deuxième couche comprenant du silicium, de l'oxygène, et du titane, sont telles que définies dans le premier objet de l'invention.

Les étapes de gravure et de dépôt de la deuxième couche sont effectuées à partir de la première couche transparente. Ces étapes peuvent être réalisées selon l'une des deux alternatives A) ou B) suivantes :
A) - graver par gravure oxydante la première couche transparente, et
   - déposer la deuxième couche comprenant du silicium, de l'oxygène, et du titane, sur la première couche transparente gravée à l'étape précédente, ou
B) - déposer la deuxième couche comprenant du silicium, de l'oxygène, et du titane, sur la première couche transparente, et
   - graver par gravure oxydante la deuxième couche comprenant du silicium, de l'oxygène, et du titane, déposée à l'étape précédente.

L'alternative A est préférée.

### Étape de gravure oxydante

Cette étape de gravure permet de conférer à l'élément optique une rugosité de surface définie par un écart moyen quadratique Rq d'au moins 20 nm.

L'étape de gravure oxydante peut être effectuée par gravure sèche, notamment du type anisotrope (i.e. gravure anisotropique), et de préférence du type ionique réactive.

Selon une forme de réalisation préférée de l'invention, l'étape de gravure oxydante met en œuvre un plasma oxydant, notamment comprenant un gaz oxydant choisi parmi l'oxygène, l'air, le protoxyde d'azote, l'azote, le tétrafluorométhane (CF₄), l'hexafluorure de soufre (SF₆) et un de leurs mélanges.

Le gaz oxydant comprend de préférence au moins 20% en mole environ d'oxygène, et de préférence encore de 30 à 100% en mole environ d'oxygène, par rapport au nombre de moles total de gaz oxydant.

### Étape de dépôt de la deuxième couche

L'étape de dépôt de la deuxième couche comprenant du silicium, de l'oxygène, et du titane, peut être effectuée par dépôt chimique en phase vapeur (CVD), et de préférence assisté par plasma. Le dépôt chimique assisté par plasma est bien connu sous l'anglicisme « Plasma-Enhanced Chemical Vapor Déposition » (PECVD) pour désigner des procédés dits « hors équilibre ».

Le dépôt PECVD [avec différentes sources : DC (courant continu), BF (basse fréquence), MF (moyenne fréquence), RF (radiofréquence), ou micro-ondes] permet de réaliser des dépôts extrêmement réticulées à basse températures, et est compatible avec les polymères utilisés dans l'élément optique de l'invention.

Le dépôt chimique en phase vapeur assisté par plasma peut être réalisé sous vide, plus précisément sous basse pression (de l'ordre de 1 à 10 Pa environ, soit 10⁻² à 10⁻¹ mbar environ), ou sous pression atmosphérique.

On peut également citer d'autres types de procédés CVD, tels que par exemple le dépôt CVD assisté laser (LECVD).

Le dépôt par plasma à pression atmosphérique est préféré.

L'étape de dépôt de la deuxième couche par CVD assisté par plasma peut mettre en œuvre un précurseur PR1 tel que défini dans le premier objet de l'invention, un précurseur PR2 tel que défini dans le premier objet de l'invention, un dopant tel que de l'azote ou un mélange azoté, et un gaz porteur oxydant tel que de l'air ou de l'oxygène.

Lorsque l'étape de dépôt de la deuxième couche par CVD assisté par plasma est effectuée à pression atmosphérique, les valeurs des débits des différents composants peuvent varier dans les limites suivantes :
- Précurseur PR1 : de 0,001 mlₛ/min à 10 lₛ/min environ ;
- Précurseur PR2 : de 0,01 mlₛ/min à 10 lₛ/min environ;
- Dopant (azote ou mélange azoté) : de 0,1 mlₛ/min à 100 lₛ/min environ ;
- Gaz porteur oxydant (air ou oxygène) : de 1 mlₛ/min à 100 lₛ/min environ.

L'unité mlₛ/min signifie « millilitre standard par minute », et l'unité lₛ/min signifie « litre standard par minute », les conditions standards correspondant à une pression de 1013 mbar et à une température de 20°C.

### Étapes additionnelles

Le procédé peut comprendre en outre une étape de dépôt d'une couche transparente de polyorganosiloxane telle que définie dans le premier objet de l'invention.

Le dépôt de cette couche transparente de polyorganosiloxane est particulièrement approprié lorsque l'alternative A) est mise en œuvre. Dans ce mode de réalisation, l'étape de dépôt de la couche transparente de polyorganosiloxane peut alors être effectuée avant la gravure de la première couche transparente. Cela permet ainsi d'améliorer la protection de la première couche transparente qui peut être sensible aux conditions oxydantes utilisées lors de l'étape ultérieure de gravure, notamment selon la nature du matériau polymère de ladite première couche transparente.

Le dépôt de cette couche transparente de polyorganosiloxane peut par exemple être approprié dans le cas où la première couche transparente comprend du PMMA.

Le dépôt de la couche transparente de polyorganosiloxane peut être effectué par dépôt chimique en phase vapeur assisté par plasma, notamment sous vide, plus précisément sous basse pression (de l'ordre de 0,1 à 10 Pa environ, soit 10⁻² à 10⁻¹ mbar environ), ou sous pression atmosphérique.

L'étape de dépôt de la couche transparente de polyorganosiloxane par CVD assisté par plasma peut mettre en œuvre un précurseur PR3 tel que défini dans le premier objet de l'invention et un gaz porteur oxydant tel que de l'air, le protoxyde d'azote ou de l'oxygène.

Lorsque l'étape de dépôt de la couche transparente de polyorganosiloxane est effectuée par CVD assisté par plasma à pression atmosphérique, les valeurs des débits des différents composants peuvent varier dans les limites suivantes :
- Précurseur PR3 : de 1 mlₛ/min à 1 lₛ/min environ ; et
- Gaz porteur oxydant (air, protoxyde d'azote ou oxygène) : de 1 mlₛ/min à 5 lₛ/min environ.

Le procédé peut comprendre en outre une étape d'hydroxylation de la deuxième couche comprenant du silicium, de l'oxygène, du titane et optionnellement de l'azote.

Cette étape permet d'hydrolyser les fonctions siloxanes présentes dans la deuxième couche et de créer des fonctions silanols, et éventuellement des fonctions Ti-OH, à la surface de cette deuxième couche. Grâce à cette étape, le caractère hydrophile de la deuxième couche est augmenté, induisant une amélioration des propriétés antibuée et de nettoyage.

La proportion de fonctions silanols Si-O-H par rapport aux fonctions Si-O est généralement de 4/1 en mole.

Cette étape est généralement effectuée après le dépôt de la deuxième couche comprenant du silicium, de l'oxygène, et du titane, et généralement avant la gravure si l'alternative B) est mise en œuvre.

L'étape d'hydroxylation peut être effectuée par traitement plasma à pression atmosphérique, notamment en présence d'un mélange gazeux de diazote et de dioxygène, en particulier dans un rapport volumique allant de 3/1 à 5/1 (e.g. 4/1).

Le procédé peut comprendre en outre une étape postérieure à l'étape d'hydroxylation par traitement plasma en présence d'hélium. Cette étape permet de bloquer les fonctions hydroxyles des groupes silanols en position externe sur la surface de l'élément optique.

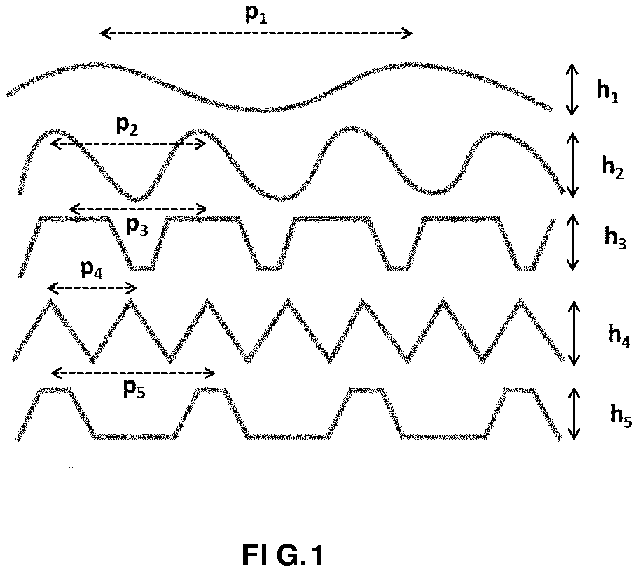

D'autres caractéristiques et avantages de la présente invention apparaîtront à la lumière de la description d'exemples non limitatifs donnés uniquement à titre illustratif et non limitatif, en référence à la figure 1 annexée.

La figure 1 est une représentation schématique d'exemples de rugosité de l'élément optique de l'invention.

Pour des raisons de clarté, seuls les éléments essentiels pour la compréhension de l'invention ont été représentés de manière schématique sur cette figure 1, et ceci sans respect de l'échelle.

En particulier, sur la figure 1, plusieurs formes de créneaux sont représentées. Les créneaux peuvent être du type sinusoïdal ayant une hauteur h₁ ou h₂ et un pas p₁ ou p₂ ; de type triangulaire ayant une hauteur h₄ et un pas p₄ ; ou du type tronc de pyramide ayant une hauteur h₃ ou h₅ et un pas p₃ ou p₅.

### Exemple

### Fabrication d'un élément optique conforme à l'invention

### 1. Étape de gravure de la première couche transparente

Le support utilisé en tant que première couche transparente est un polycarbonate (PC) transparent, commercialisé par la société KUDEB sous la référence Makrolon AL 2447. Ce support est sous forme d'une plaque rectangulaire avec les dimensions suivantes : 100 mm de longueur, 100 mm de largeur, et 2,5 mm d'épaisseur.

L'étape de gravure oxydante par plasma oxydant atmosphérique est mise en œuvre sur la première couche transparente.

L'étape de gravure est effectuée sur le support tel que décrit ci-dessus à l'aide d'une torche plasma à pression atmosphérique comprenant une électrode interne reliée à un générateur haute tension à fréquence variable et une buse permettant de transférer le plasma vers le support.

Le gaz d'ionisation est le dioxygène. Le débit de gaz est de 50 litres par minute. La fréquence du générateur est fixée à 25 kHz, la tension appliquée est fixée à 400 volts, la distance buse/source au support est de 6 mm et la vitesse de déplacement de la buse par rapport au support est de 10 mètres par minute.

On obtient ainsi une première couche transparente de polycarbonate gravée.

### 2. Étape de dépôt de la deuxième couche comprenant du silicium, de l'oxygène, du titane et un dopant

L'étape de dépôt de la deuxième couche comprenant du silicium, de l'oxygène, du titane et de l'azote en tant que dopant, à l'aide d'une torche à plasma atmosphérique, est ensuite mise en œuvre.

Les composés suivants sont utilisés pour la préparation de la deuxième couche transparente :
- PR1 : TEOS commercialisé par la société Sigma Aldrich sous la référence 86578 pureté ≥ 99% (CAS No. 78-10-4) ;
- PR2: TIPP commercialisé par la société Sigma Aldrich sous la référence 87560 pureté ≥ 97% (CAS No. 546-68-9) ; et
- l'azote utilisé comme gaz porteur, gaz d'ionisation et dopant : commercialisé par la société Air Liquide sous la référence Alphagaz 1 Azote (CAS No. 7727-37-9).

Le rapport massique TEOS/TIPP est de 80/20.

Un générateur alimente une électrode interne avec une tension variant de 200 à 450 volts et une intensité variant de 10 à 30 ampères (fréquence de 20-25 kHz).

Le débit du précurseur PR1 TEOS est de 8 lₛ/min et le débit du précurseur PR2 TIPP est de 2 lₛ/min, et le débit de gaz dopant (N₂) varie de 10 à 30 lₛ/min.

La fréquence du générateur est fixée à 20 kHz, la tension appliquée est fixée à 350 volts, la distance buse/source au support est de 15 mm et la vitesse de déplacement de la buse par rapport au support est de 100 mètres par minute. La température du gaz porteur est de 200°C.

On obtient ainsi un élément optique selon l'invention comprenant une première couche transparente de polycarbonate gravée recouverte d'une deuxième couche de silicium, titane, oxygène et azote.

La deuxième couche a une épaisseur d'environ 20 nm.

Cette deuxième couche est caractérisée par MEB/EDS (Microscope électronique à balayage équipé d'une sonde). Elle comprend une structure de type « core/shell » (noyau/enveloppe), dans laquelle au moins une particule de SiO₂ est recouverte par une enveloppe de nanoparticules de TiO₂₋ₓNₓ distribuées à la surface de ladite particule de SiO₂.

### 3. Étape d'hydroxylation de la deuxième couche

Le support est ensuite soumis à une étape d'hydroxylation à l'aide d'une torche à plasma atmosphérique. Le gaz d'ionisation est un mélange de diazote et de dioxygène dans un rapport volumique 4/1. Le débit de gaz est de 50 litres par minute. La fréquence du générateur est fixée à 22 kHz, la tension appliquée est fixée à 300 volts, la distance buse/source au support est de 10 mm et la vitesse de déplacement de la buse par rapport au support est de 30 mètres par minute.

### 4. Étape de traitement plasma en présence d'hélium de la deuxième couche

Le support est ensuite soumis à un traitement plasma en présence d'hélium. Un générateur alimente une électrode interne avec une tension de 300 volts, une intensité de 20 ampères et une fréquence de 25 kHz. Le débit d'hélium est de 20 à 50 lₛ/min. La distance buse/source au support est de 15 mm.

### 5. Caractérisation de l'élément optique conforme à l'invention

### 5. a. Caractérisation des propriétés antibuée

Les propriétés antibuée ont été caractérisées à l'aide d'un test d'exposition de l'élément optique à la vapeur d'eau en l'exposant au-dessus d'un bain d'eau chauffé et maintenu à une température de 78°C (± 10°C). L'élément optique est positionné à 20 cm au-dessus du niveau de l'eau jusqu'à saturation de la surface exposée (ruissellement de l'eau condensée).

L'élément optique est resté parfaitement transparent à l'œil. Aucune perte en transmission n'a été observée sur la surface de l'élément optique, ce qui permet de montrer ses propriétés antibuée.

### 5. b. Caractérisation des propriétés photocatalytiques

L'activité photocatalytique est mesurée en exposant à la lumière strictement visible (400 nm ≤ λ ≤ 800 nm), la surface de l'élément optique tel qu'obtenu ci-dessus.

Pour ce faire, l'élément optique est placé dans des boîtes de Petri contenant une solution de bleu de méthylène (indicateur coloré organique). Les boîtes de Petri sont ensuite placées dans une enceinte opaque avec une ouverture dans sa partie supérieure réalisée avec un filtre passe-visible (400 nm < λ < 800 nm) au-dessus duquel une lampe halogène est allumée.

On observe visuellement une décoloration de la solution de bleu de méthylène en moins de 30 minutes, ce qui montre l'effet photocatalytique dans le visible de l'élément optique conforme à l'invention.

### 5. c. Effet de la texturation/rugosité

La rugosité du support en polycarbonate (PC) transparent tel que décrit ci-dessus (première couche transparente) a été mesurée à l'aide d'un microscope à force atomique.

Ledit support présente un écart moyen quadratique Rq de 19,1 nm environ.

Par comparaison, l'élément optique tel qu'obtenu à l'issue de l'étape 2 décrite ci-dessus présente un écart moyen quadratique Rq de 65,2 nm environ.

L'angle de contact de l'eau est mesuré à l'aide d'un analyseur d'angle de contact Krüss DSA 25 selon la norme ASTM D 724-99.

Ledit support présente un angle de contact de l'eau de 10°, tandis que l'angle de contact de l'élément optique est inférieur à 5°.

Le support et l'élément optique sont ensuite stockés à 23°C sans protection. Après 28 jours, ledit support présente un angle de contact de l'eau de 20°, tandis que l'angle de contact de l'élément optique est de 11°.

Cela permet de montrer que l'élément optique de l'invention présente une superhydrophilie qui se maintient au cours du temps.

## Revendications

1. Élément optique pour véhicule automobile, comprenant au moins une première couche transparente contenant un matériau polymère, et au moins une deuxième couche comprenant au moins du silicium, du titane, et de l'oxygène, **caractérisé en ce que** l'élément optique présente une rugosité de surface de la deuxième couche, définie par un écart moyen quadratique Rq supérieur ou égal à 20 nm.

2. Élément optique selon la revendication 1, **caractérisé en ce que** la deuxième couche comprend en outre au moins un dopant choisi parmi les éléments chimiques du tableau périodique des éléments ayant une dimension atomique variant de 1 à 4 À.

3. Élément optique selon la revendication 1 ou 2, **caractérisé en ce qu'**il présente une rugosité définie par un écart moyen quadratique d'au moins 50 nm.

4. Élément optique selon l'une quelconque des revendications précédentes, **caractérisé en ce que** la deuxième couche de l'élément optique comprend :
- un ou plusieurs groupement(s) silicium-oxygène (Si-O), et
- un ou plusieurs groupement(s) titane-oxygène (Ti-O).

5. Élément optique selon la revendication 4, **caractérisé en ce que** la deuxième couche comprend en outre un ou plusieurs groupement(s) silicium-oxygène-hydrogène (Si-O-H).

6. Élément optique selon l'une quelconque des revendications 2 à 5, **caractérisé en ce que** la deuxième couche comprend de 0,0001% à 10% en poids de dopant, par rapport au poids total de la deuxième couche.

7. Élément optique selon l'une quelconque des revendications précédentes, **caractérisé en ce que** la première couche transparente comprend au moins 50% en poids de matériau polymère, par rapport au poids total de la première couche.

8. Élément optique selon l'une quelconque des revendications précédentes, **caractérisé en ce que** la première couche transparente ou la deuxième couche comprenant du silicium, de l'oxygène, et du titane, est une couche gravée.

9. Élément optique selon l'une quelconque des revendications précédentes, **caractérisé en ce qu'**il comprend en outre une couche transparente de polyorganosiloxane.

10. Élément optique selon la revendication 9, **caractérisé en ce que** la couche transparente de polyorganosiloxane est positionnée entre la première couche transparente et la deuxième couche comprenant du silicium, de l'oxygène, et du titane.

11. Dispositif lumineux de véhicule automobile comprenant un élément optique tel que défini à l'une quelconque des revendications précédentes.

12. Procédé de fabrication d'un élément optique tel que défini à l'une quelconque des revendications 1 à 10, **caractérisé en ce qu'**il comprend, à partir de la première couche transparente, au moins les étapes suivantes :
- une étape de gravure oxydante, et
- une étape de dépôt de la deuxième couche comprenant du silicium, de l'oxygène, et du titane.

13. Procédé selon la revendication 12, **caractérisé en ce que** les étapes de gravure et de dépôt de la deuxième couche sont réalisées selon l'une des deux alternatives A) ou B) suivantes :
A) - graver par gravure oxydante la première couche transparente, et
- déposer la deuxième couche comprenant du silicium, de l'oxygène, et du titane, sur la première couche transparente gravée à l'étape précédente, ou
B) - déposer la deuxième couche comprenant du silicium, de l'oxygène, et du titane, sur la première couche transparente, et
- graver par gravure oxydante la deuxième couche comprenant du silicium, de l'oxygène, et du titane, déposée à l'étape précédente.

14. Procédé selon la revendication 12 ou 13, **caractérisé en ce que** l'étape de gravure oxydante est effectuée par gravure sèche.

15. Procédé selon l'une quelconque des revendications 12 à 14, **caractérisé en ce qu'**il comprend en outre une étape d'hydroxylation de la deuxième couche comprenant du silicium, de l'oxygène, et du titane.

## Patentansprüche

1. Optisches Element für ein Kraftfahrzeug, das mindestens eine transparente erste Schicht, die ein polymeres Material enthält, und mindestens eine Silicium, Titan und/oder Sauerstoff umfassende zweite Schicht umfasst, **dadurch gekennzeichnet, dass** das optische Element eine Oberflächenrauheit der zweiten Schicht aufweist, die durch eine mittlere quadratische Abweichung Rq größer als oder gleich 20 nm definiert ist.

2. Optisches Element nach Anspruch 1, **dadurch gekennzeichnet, dass** die zweite Schicht weiterhin mindestens einen Dotierungsstoff umfasst, der aus den chemischen Elementen des Periodensystems mit einer von 1 bis 4 Ä reichenden Atomgröße ausgewählt ist.

3. Optisches Element nach Anspruch 1 oder 2, **dadurch gekennzeichnet, dass** es eine Rauheit aufweist, die durch eine mittlere quadratische Abweichung von mindestens 50 nm definiert ist.

4. Optisches Element nach einem der vorhergehenden Ansprüche, **dadurch gekennzeichnet, dass** die zweite Schicht des optischen Elements Folgendes umfasst:
- eine oder mehrere Silicium-Sauerstoff- (Si-O-)Gruppen und
- eine oder mehrere Titan-Sauerstoff- (Ti-O-)Gruppen.

5. Optisches Element nach Anspruch 4, **dadurch gekennzeichnet, dass** die zweite Schicht weiterhin eine oder mehrere Silicium-Sauerstoff-Wasserstoff- (Si-O-H-)Gruppen umfasst.

6. Optisches Element nach einem der Ansprüche 2 bis 5, **dadurch gekennzeichnet, dass** die zweite Schicht von 0,0001 Gew.-% bis 10 Gew.-% Dotierungsstoff, bezogen auf das Gesamtgewicht der zweiten Schicht, umfasst.

7. Optisches Element nach einem der vorhergehenden Ansprüche, **dadurch gekennzeichnet, dass** die transparente erste Schicht mindestens 50 Gew.-% polymeres Material, bezogen auf das Gesamtgewicht der ersten Schicht, umfasst.

8. Optisches Element nach einem der vorhergehenden Ansprüche, **dadurch gekennzeichnet, dass** die transparente erste Schicht oder die Silicium, Sauerstoff und Titan umfassende zweite Schicht eine geätzte Schicht ist.

9. Optisches Element nach einem der vorhergehenden Ansprüche, **dadurch gekennzeichnet, dass** es außerdem eine transparente Polyorganosiloxanschicht umfasst.

10. Optisches Element nach Anspruch 9, **dadurch gekennzeichnet, dass** die transparente Polyorganosiloxanschicht zwischen der transparenten ersten Schicht und der Silicium, Sauerstoff und Titan umfassenden zweiten Schicht angeordnet ist.

11. Kraftfahrzeug-Leuchtvorrichtung, die ein optisches Element gemäß der Definition in einem der vorhergehenden Ansprüche umfasst.

12. Verfahren zur Herstellung eines optischen Elements gemäß der Definition in einem der Ansprüche 1 bis 10, **dadurch gekennzeichnet, dass** es ausgehend von der transparenten ersten Schicht zumindest die folgenden Schritte umfasst:
- einen Schritt des oxidativen Ätzens und
- einen Schritt des Abscheidens der Silicium, Sauerstoff und Titan umfassenden zweiten Schicht.

13. Verfahren nach Anspruch 12, **dadurch gekennzeichnet, dass** die Schritte des Ätzens und des Abscheidens der zweiten Schicht gemäß einer der folgenden beiden Alternativen A) oder B) erfolgen:
A) - Ätzen der ersten transparenten Schicht durch oxidatives Ätzen und
- Abscheiden der Silicium, Sauerstoff und Titan umfassenden zweiten Schicht auf der im vorhergehenden Schritt geätzten transparenten ersten Schicht, oder
B) - Abscheiden der Silicium, Sauerstoff und Titan umfassenden zweiten Schicht auf der transparenten ersten Schicht und
- Ätzen der im vorhergehenden Schritt abgeschiedenen Silicium, Sauerstoff und Titan umfassenden zweiten Schicht durch oxidatives Ätzen.

14. Verfahren nach Anspruch 12 oder 13, **dadurch gekennzeichnet, dass** der Schritt des oxidativen Ätzens durch Trockenätzen erfolgt.

15. Verfahren nach einem der Ansprüche 12 bis 14, **dadurch gekennzeichnet, dass** es weiterhin einen Schritt der Hydroxylierung der Silicium, Sauerstoff und Titan umfassenden zweiten Schicht umfasst.

## Claims

1. Optical element for a motor vehicle, comprising at least one transparent first layer containing a polymer material, and at least one second layer comprising at least silicon, titanium and oxygen, **characterized in that** the optical element has a surface roughness of the second layer defined by a mean square deviation Rq greater than or equal to 20 nm.

2. Optical element according to Claim 1, **characterized in that** the second layer also comprises at least one dopant chosen from the chemical elements of the Periodic Table of Elements which have an atomic size ranging from 1 to 4 Å.

3. Optical element according to Claim 1 or 2, **characterized in that** it has a roughness defined by a mean square deviation of at least 50 nm.

4. Optical element according to any one of the preceding claims, **characterized in that** the second layer of the optical element comprises:
- one or more silicon-oxygen (Si-O) group(s), and
- one or more titanium-oxygen (Ti-O) group(s).

5. Optical element according to Claim 4, **characterized in that** the second layer also comprises one or more silicon-oxygen-hydrogen (Si-O-H) group(s).

6. Optical element according to any one of Claims 2 to 5, **characterized in that** the second layer comprises from 0.0001% to 10% by weight of dopant, relative to the total weight of the second layer.

7. Optical element according to any one of the preceding claims, **characterized in that** the transparent first layer comprises at least 50% by weight of polymer material, relative to the total weight of the first layer.

8. Optical element according to any one of the preceding claims, **characterized in that** the transparent first layer or the second layer comprising silicon, oxygen and titanium is an etched layer.

9. Optical element according to any one of the preceding claims, **characterized in that** it also comprises a transparent layer of polyorganosiloxane.

10. Optical element according to Claim 9, **characterized in that** the transparent layer of polyorganosiloxane is positioned between the transparent first layer and the second layer comprising silicon, oxygen and titanium.

11. Motor vehicle luminous device comprising an optical element as defined in any one of the preceding claims.

12. Process for manufacturing an optical element as defined in any one of Claims 1 to 10, **characterized in that** it comprises, starting from the transparent first layer, at least the following steps:
- an oxidative etching step, and
- a step of depositing the second layer comprising silicon, oxygen and titanium.

13. Process according to Claim 12, **characterized in that** the etching step and the step of depositing the second layer are carried out according to one of the following two alternatives A) or B):
A) - etching, by oxidative etching, the transparent first layer, and
- depositing the second layer comprising silicon, oxygen and titanium, on the transparent first layer etched in the preceding step,
or
B) - depositing the second layer comprising silicon, oxygen and titanium, on the transparent first layer, and
- etching, by oxidative etching, the second layer comprising silicon, oxygen and titanium, deposited in the preceding step.

14. Process according to Claim 12 or 13, **characterized in that** the oxidative etching step is carried out by dry etching.

15. Process according to any one of Claims 12 to 14, **characterized in that** it also comprises a step of hydroxylation of the second layer comprising silicon, oxygen and titanium.
